# EUROPEAN PATENT SPECIFICATION

(11) **EP 0 389 824 B1**
(45) Date of publication and mention of the grant of the patent: **19.01.1994**
(21) Application number: 90104115.2
(22) Date of filing: 02.03.1990
(51) Int. Cl.: G02B 6/42

(54) **Transient voltage suppression for electro-optic modules**
Unterdrückung von transienten Spannungen für elektro-optische Module
Suppression des tensions transitoires pour des modules électro-optiques

(30) Priority: 29.03.1989 CA 595111
(43) Date of publication of application: 03.10.1990
(73) Proprietor: NORTHERN TELECOM LIMITED, Montreal Quebec H3B 4N7 (CA)
(72) Inventor: Tabalba, Camilo M., Kanata, Ontario, K2K 1V3 (CA); Koens, Paul John, Ontario, K0A 1B0 (CA); Lommen, Joseph John, Nepean, Ontario, K2H 9C7 (CA)
(74) Representative: TER MEER STEINMEISTER & PARTNER GbR

(56) References cited:
- EP-A- 0 267 074
- EP-A- 0 279 359
- DE-A- 2 741 585
- EOSD ELECTRO-OPTICAL SYSTEMS DESIGN. vol. 11, no. 10, October 1979, CHICAGO US pages 29 - 33; J. KESSLER: "Fiber-optic connectors: Prices drop, Performance rises"

## Description

### Field of the Invention

This invention relates to fiber optic modules for fiber optic links used to connect various system elements in a telephone switching system.

### Background of the Invention

In a telephone switching system using fiber optic links between various system elements, electro-optic transmitter and receiver modules are used to terminate each end of the optical link. Each serve as the electronic/optical interfaces between the equipment and the fiber. Electronic equipment must be protected from electro-static voltage (ESD), or transient voltages which it may be exposed to, by adjacent equipment, or craftsperson servicing the equipment. Such destructive voltages may be in the range of a few hundred volts to thousands of volts.

Because total protection from ESD is very difficult, separation of the electronic ground return path became a common practice. Any hits from ESD may then be conducted on metallic surfaces to the frame ground, which is in turn solidly connected to the regulatory building ground. Although optical signals are not affected by ESD, the electrical components can be.

Physically, the modules are located on a circuit card which is attached to one side of the backplane. In some instances, up to twelve modules including associated clock recovery circuits are located on such a card. Because of the small size of the card, which can be 10.5 x 3.5 inch (26.7 x 8.9 cm), and the need to locate the modules close to the faceplate to make the optical receptacle accessible, small module size is required. In addition, the module should be able to relieve strain to the hybrid from forces associated with the fiber optic connector and cable, provide general mechanical protection, EMI shielding with grounding, heat transfer away from electronic components, and provide minimal resistance to the general flow of cooling air over the PCB.

Although electro-optic modules of small size already exist, these have an optical connector with a metallic liner or shell to provide increased rigidity. Even with the connector grounded to the equipment ground, it was found that unwanted signals and high voltage transients were affecting the operation of the internal components of the module, and other electronic circuits on the circuit card.

DE-A-2 741 585 discloses an electro-optic module having an optical connector with a connecting end adapted to receive and secure an optical fiber cable. Although a portion of this connecting end may be made of plastic, the connecting end as a whole is not electrically isolated from the members carrying the electronic components, so that the electronic circuits may be affected by high voltage transients.

There is accordingly a need for an improved electro-optic module able to sustain high voltage transients, able to eliminate unwanted signals while retaining its small size and rigidity as well as meeting the above requirements.

### Summary of the Invention

It is therefore an object of the present invention to provide an improved electro-optic module and grounding scheme which will provide a discharge path for high voltage transients, away from the module containing the electronic and opto-devices, while meeting the above design requirements.

This object is achieved with the features indicated in claim 1.

In an electro-optic module according to the invention, the connecting end of the optical connector, which is adapted to receive and secure the optical cable, is electrically isolated from the circuit board carrying the electronic components, and the connector is further provided with means forming a discharge path, such that high voltage transients are directed away from the circuit board.

According to one embodiment, the discharge path forming means are formed by an electrically conductive liner which surrounds the connecting end of the optical connector and is spaced apart from the portion of the connector which is connected to the circuit board.

In another embodiment, the discharge path forming means are formed by the connecting end of the optical connector itself, and an isolator is provided between said connecting end and the portion connected to the circuit board.

More specific optional features of the invention are indicated in the dependent claims.

### Brief Description of the Drawings

Preferred embodiments of the invention will now be described in conjunction with the accompanying drawings in which:
Figures 1a and 1b are front and side views of a typical card showing the placement of electro-optic connectors;
Figures 2a and 2b are front and side views of an electro-optic module according to a first embodiment of the invention;
Figure 3 is a sectional view taken along lines 3-3 of Figure 2a;
Figure 4 is a diagrammatical representation of the discharge path taken by high voltage transients with the module of Figure 3;
Figure 5 is a sectional view of an electro-optic module according to a second embodiment of the invention; and
Figure 6 is a diagrammatical representation of the discharge path taken by high voltage transients with the module of Figure 5.

### Description of the Preferred Embodiment

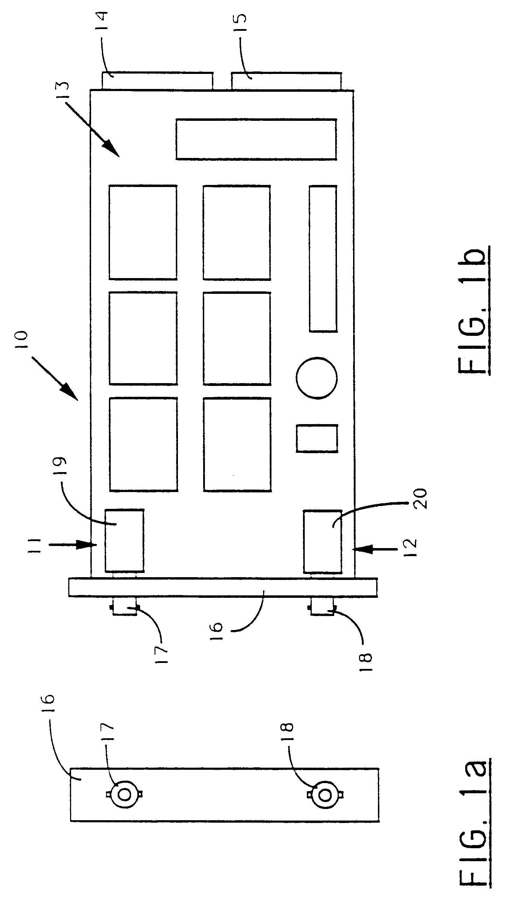

Referring now to Figures 1a and 1b, we have shown a front and side view of a typical connecting card 10 used on backplanes of telephone switching systems. As indicated above, advanced telephone switches now make use of electrooptic modules 11 and 12 to send and receive high speed information. For example, module 11 could be used as a receiving module, whereas module 12 could be used as a transmitting module. Card 10 supports various electronic components 13 and is connected to the backplane of the switch using multi-pin connectors 14 and 15. A face plate 16 separates the optical connectors 17 and 18 of modules 11 and 12 from the modules' enclosures 19 and 20 and from the other electronic components 13. Optical fibers can be connected to modules 11 and 12 using the necessary optical connectors adapted to match connectors 17 and 18.

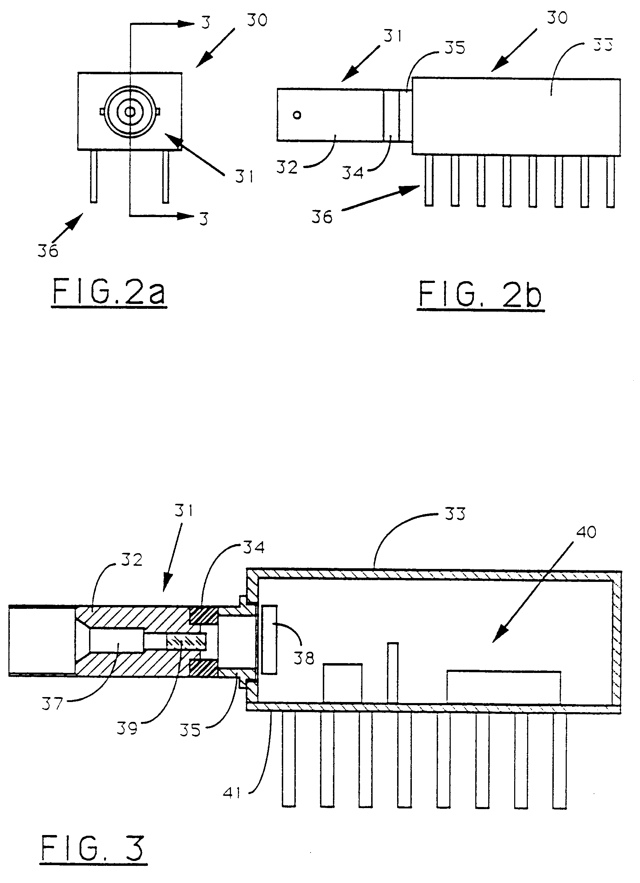

In Figures 2a and 2b, we have shown a front and side view of an electro-optic module according to a first embodiment of the invention. A module 30 which corresponds to the module 11 or 12 in Fig 1b is comprised of an optical connector 31 having a first portion 32 used as a connecting end and which is adapted to receive and secure an optical fiber cable and an enclosure 33 containing a circuit board with various electro-optic components. Enclosure 33 can be a conventional housing for electronic components. It is however, not required for the purpose of transient suppression, but is normally used to shield the electronic and optical devices from electromagnetic interference, or to reduce electromagnetic radiation. The enclosure 33 is attached to the optical connector 31, but is electrically isolated therefrom by means of an isolator 34 separating the first portion 32 of the connector 31 from a second portion 35 attached to the enclosure 33. A series of connecting pins 36 are used to secure and electrically connect the circuit board and module 30 to the support card shown in Figure 1.

Figure 3 is a sectional view of the electro-optic module of Figure 2a. As seen in Figure 3, the first portion 32 of connector 31, is isolated from the second portion 35 and enclosure 33 by means of a ring-shaped isolator 34. The ring-shaped isolator allows light travelling through optical channel 37 to reach electro-optic transducer 38. Light may be focused on the transducer 38 by suitable means, such as a GRIN (graded index) lens 39 or equivalent. The electro-optic transducer 38 may contain an LED or LASER diode, or it may have an optical detector. Various electro-optic components 40 are supported on circuit board 41 and attached to the connector 31 via the second portion 35, thereby isolating the electro-optic components from high voltage transients, which may affect these as well as other electronic components on the card. However, the optical channel 37 is not affected by transient voltages, electromagnetic interference or radiation.

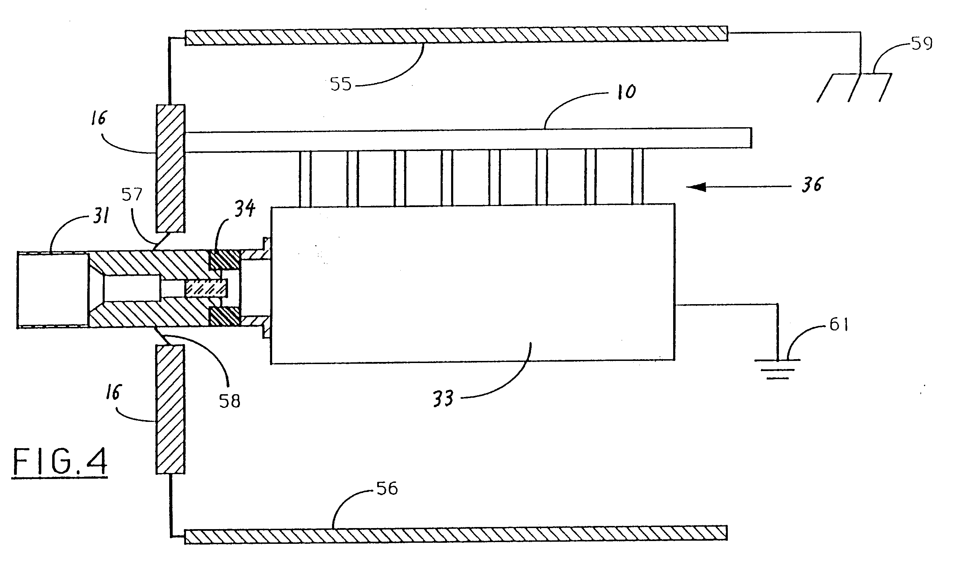

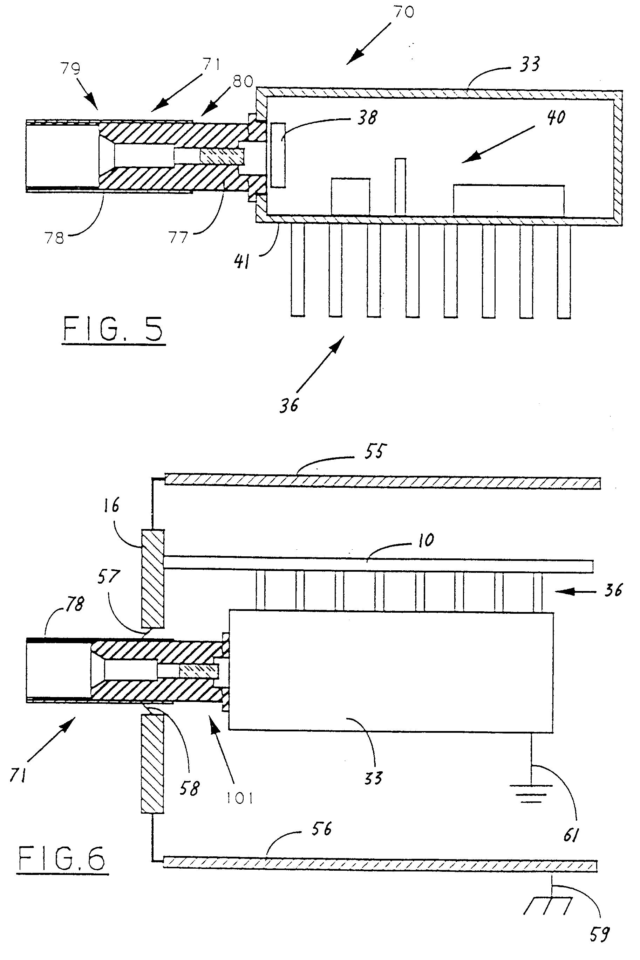

Figure 4 is a grounding scheme representation using the electro-optic module of the present invention. In a typical telephone switch, a plurality of cards are placed side by side on a mounting rack to form a series of shelves. When placed on the shelves, the cards are slid into individual slots to become connected to the backplane. Figures 4 and 6 are simple representations of the grounding scheme used with the electro-optic module embodiments of Figures 3 and 5. In the embodiment of Figure 4, reference numeral 10 represents the removable card, having face plate 16. The face plate is conventionally present in equipment design practice. The plate 16 has a conductive surface, if it is not made of metal. The electro-optic module has its optical connector 31 extending therethrough. The enclosure 33 is secured to card 10 and electrically connected thereto by means of pins 36. The frame of the telephone switch is represented by side walls 55 and 56 which are connected to an earth ground 59. If a high voltage transient is carried along the metallic liner of the optic fiber, it will be discharged via a physical conductive path 57 or 58 to the equipment frame 55 or 56 and eventually to the earth ground 59. Isolator 34 isolates the circuit card from any harmful effects of the transient voltages, without affecting the operation of the electro-optic module and its components. A power supply or logic ground 61 is provided for the circuit board and the electro-optic components. The practice of using an earth ground separated from a logic ground eliminates the effects of unwanted frame ground induced currents from affecting the supply ground and electro-optic components.

Figure 5 is a sectional view of an electro-optic module 70 according to a second embodiment of the invention. As seen in Figure 5, the module 70 is comprised of an optical connector 71 and the enclosure 33 disposed over the circuit board 41 having connecting pins 36. Various electro-optic components 40 are used to convert optical energy to electrical energy, or vice-versa with transducer 38. However, in this embodiment, the optical connector 71 is comprised of a single connecting element 77 made of non-conductive material. A discharge path away from the enclosure 33 and circuit board 41 is provided by means of a conductive outer shell or liner 78 disposed around the connecting element 77. The liner extends from the connecting end 79 to a point 80 along the connector away from the enclosure 33 and circuit board 41. Accordingly, the enclosure 33 and circuit board 41 are isolated from the connector by the gap created between the liner 78 and the edge of the enclosure.

Figure 6 is a grounding scheme representation using the electro-optic module of Figure 5. Similarly, as with the grounding scheme arrangement of Figure 4, the physical juxtaposition of elements is the same. The electro-optic module has its optical connector 71 extending therethrough. The enclosure 33 is secured to card 10 and electrically connected thereto by means of pins 36. The frame of the telephone switch is represented by side walls 55 and 56 which are connected to earth ground 59. However, in this embodiment, if a high voltage transient or unwanted signal is carried along the metallic liner of the optic fiber, it will be discharged via the metallic liner 78 of connector 71 through physical conductive path 57 or 58 to the equipment frame 55 or 56 and eventually to the earth ground 59. The gap 101 created between liner 78 and enclosure 33 will isolate the circuit card from any damaging effects unwanted signals might have on the module, when carried along the fiber. The power supply or logic ground 61 is provided for the circuit board and the electro-optic components. This practice eliminates the effect of unwanted frame ground induced currents from affecting the supply ground and electro-optic components.

## Claims

1. An electro-optic module (11;12;30;70) for connecting to an optical fiber, comprising:
an optical connector (17;18;31;71) having a connecting end (32;79) adapted to receive and secure an optical fiber cable; and
a circuit board (41) attached to said optical connector, **characterized** in that said connecting end (32;79) of said connector is electrically isolated from the circuit board (41); and
said connector is provided at the connecting end thereof with means (32;78) forming a discharge path, such that high voltage transients carried along a metallic liner of the optical fibre are directed away from said circuit board.

2. An electro-optic module as defined in claim 1, wherein said optical connector (71) is made of non-conductive material and said discharge path forming means comprise a conductive outer shell (78) disposed around said optical connector (71) and extending from said connecting end (79) to a point (80) along said connector, which is disposed away from said circuit board (41).

3. An electro-optic module as defined in claim 1, wherein said optical connector (31) is comprised of:
a first portion (32) forming said connecting end and having an outer shell with an optical fiber receptacle disposed centrally thereof, said first portion having means for receiving and securing said optical fiber;
a second portion (35) for connecting to said circuit board (41); and
an isolator (34) separating said first portion from said second to isolate said circuit board from said first portion, said discharge path forming means being formed by said first portion (32) of said optical connector.

4. An electro-optic module as defined in claim 3, wherein said isolator (34) is ring-shaped.

5. An electro-optic module as defined in claim 4, wherein said isolator (34) is made of a ceramic material.

## Patentansprüche

1. Elektro-optischer Modul (11; 12; 30; 70) für den Anschluß an eine optische Faser, mit:
einem optischen Anschlußteil (17; 18; 31; 71) mit einem Anschlußende (32; 79), das zur Aufnahme und Befestigung eines optischen Faserkabels ausgebildet ist, und
einer an dem optischen Anschlußteil befestigten Schaltungsplatine (41), dadurch **gekennzeichnet**,
daß das Anschlußende (32; 79) des Anschlußteils elektrisch von der Schaltungsplatine (41) isoliert ist und
daß der Anschlußteil an seinem Anschlußende mit Mitteln (32; 78) zur Bildung eines Entladungspfades versehen ist, so daß längs der metallischen Umhüllung der optischen Faser geleitete hohe Transientenspannungen von der Schaltungsplatine weggeführt werden.

2. Elektro-optischer Modul nach Anspruch 1, bei dem der optische Anschlußteil (71) aus nichtleitendem Material besteht und die Mittel zur Bildung des Entladungspfades eine leitende äußere Hülle (78) aufweisen, die um den optischen Anschlußteil (71) herum angeordnet ist und sich vom Anschlußende (79) bis zu einem Punkt (80) auf der Länge des Anschlußteils erstreckt, der zu der Schaltungsplatine (41) entfernt liegt.

3. Elektro-optischer Modul nach Anspruch 1, bei dem der optische Anschlußteil (31) aufweist:
einen ersten Bereich (32), der das Anschlußende bildet und eine äußere Hülle mit einer mittig darin angeordneten Aufnahme für eine optische Faser aufweist, welcher erste Bereich mit Mitteln zur Aufnahme und Befestigung der optischen Faser versehen ist,
einen zweiten Bereich (35) Zur Verbindung mit der Schaltungsplatine (41) und
einen Isolator (34), der den ersten Bereich von dem zweiten trennt, um die Schaltungsplatine von dem ersten Bereich zu isolieren, wobei die Mittel zur Bildung des Entladungspfades durch den ersten Bereich (32) des optischen Anschlußteils gebildet werden.

4. Elektro-optischer Modul nach Anspruch 3, bei der der Isolator (34) ringförmig ist.

5. Elektro-optischer Modul nach Anspruch 4, bei der der Isolator (34) aus einem keramischen Material besteht.

## Revendications

1. Module électro-optique (11 ; 12 ; 30 ; 70) pour connexion à une fibre optique, comprenant :
un connecteur optique (17 ; 18 ; 31 ; 71) ayant une extrémité de connexion (32 ; 79) prévu pour recevoir et fixer un câble à fibres optiques, et
une carte de circuits (41) fixée au connecteur optique, caractérisé en ce que l'extrémité de connexion (32 ; 79) du connecteur est électriquement isolée de la carte de circuits (41), et
le connecteur est muni à son extrémité de connexion d'un moyen (32 ; 78) formant un trajet de décharge, de sorte que des transitoires de tension élevée propagés suivant un revêtement métallique de la fibre optique sont dirigés loin de la carte de circuits.

2. Module électro-optique selon la revendication 1, dans lequel le connecteur optique (71) est constitué d'un matériau non conducteur et le moyen de formation de trajet de décharge comprend une enveloppe extérieure conductrice (78) disposée autour du connecteur optique (71) et se prolongeant à partir de l'extrémité de connexion (79) jusqu'à un point (80) suivant le connecteur, qui est disposé loin de la carte de circuits (41).

3. Module électro-optique selon la revendication 1, dans lequel le connecteur optique (31) est constitué de :
une première partie (32) formant l'extrémité de connexion et ayant une enveloppe extérieure avec un réceptacle de fibre optique disposé au centre de celle-ci, la première partie ayant un moyen pour recevoir et fixer la fibre optique ;
une seconde partie (35) pour la connexion à une carte de circuits (41), et
un isolateur (34) séparant la première partie de la seconde partie afin d'isoler la carte de circuits de la première partie, le moyen de formation de trajet de décharge étant formé par la première partie (32) du connecteur optique.

4. Module électro-optique selon la revendication 3, dans lequel ledit isolateur (34) est en forme de bague.

5. Module électro-optique selon la revendication 4, dans lequel l'isolateur (34) est constitué d'un matériau de céramique.
